**Europäisches Patentamt**

**European Patent Office**

**Office européen des brevets**

(11) Publication number: **0 070 061**
**B1**

(12) **EUROPEAN PATENT SPECIFICATION**

(45) Date of publication of patent specification: **15.01.86**

(51) Int. Cl.⁴: **C 23 C 18/42**

(21) Application number: **82200808.2**

(22) Date of filing: **30.06.82**

(54) A solution for the electroless deposition of gold-alloys onto a substrate.

(30) Priority: **02.07.81 NL 8103174**

(43) Date of publication of application:
**19.01.83 Bulletin 83/03**

(45) Publication of the grant of the patent:
**15.01.86 Bulletin 86/03**

(84) Designated Contracting States:
**AT BE CH DE FR GB IT LI NL SE**

(56) References cited:
**CH-A- 413 540**
**DE-B-1 258 699**
**GB-A-1 322 203**
**GB-A-2 083 080**
**US-A-3 468 676**

(73) Proprietor: **N.V. Philips' Gloeilampenfabrieken**
**Groenewoudseweg 1**
**NL-5621 BA Eindhoven (NL)**

(72) Inventor: **Molenaar, Arian**
**c/o INT.OCTROOIBUREAU B.V. Prof.Holstlaan 6**
**NL-5656 AA Eindhoven (NL)**

(74) Representative: **Jelmorini, Pius Antonius et al**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to a solution for the electroless deposition of gold-alloys onto a substrate, to the method making use of the solution and to the use of the solution for the provision of a layer or a pattern of gold or a gold-alloy onto a semiconductor device on the basis of a III-V compound.

United Kingdom Patent Specification 1,322,203 discloses such a method, in accordance with which alkalimetal borohydrides and alkyl-substituted amino boranes are used as reducing agents. The relevant solutions, which contain a water-soluble gold salt, an alkaline compound and a cyanide as the complex-forming agent, and optionally salts of other metals, are rather instable. To improve the stability a large amount of free cyanide is usually added in concentrations larger than or equal to 0.01 mole/l when the gold compound is chosen in the form of the cyanoaurate complex. Moreover, the rather high temperature (70 to 80°C) at which the bath must be operated, and the instability still prevailing have hampered the practical usage.

A solution is known from the US Patent Specification 3,468,676 for the deposition of gold onto metal objects or onto objects having a metal surface layer. Said solution contains gold in the form of a gold cyanide complex, and a water-soluble salt of one of the metals palladium, cobalt, rhodium, platinum, copper and silver in a quantity between 0.1 and 10 g/l. A characteristic feature of all the solutions in accordance with this US Patent Specification is a high concentration of ammonium hydroxide, calculated as $NH_3$ in a quantity between 20 g/l and the saturation concentration. The solution may optionally contain admixtures of up to 100 ml/l of a 37% formaldehyde solution or an equivalent quantity of a different strength, up to 10 g/l of sodium or potassium citrate and up to 100 g/l of alkalimetal-hypophosphite. This solution is operated at a temperature which is preferably between 70 and 80°C. The volatility of the ammonia which is present in a high concentration is an unavoidable drawback during manufacturing circumstances, owing to the high degree of corrosiveness and the unbearable stench of the $NH_3$-gas.

It is an object of the invention to provide a solution for the electroless deposition of gold and gold-alloys onto a substrate, which does not have the above-described drawbacks and in which not only metallic but also non-metallic surfaces can be plated.

The prior British Patent Application 8126486, published in the meantime as GB—A—2083080 describes a method of producing layers or patterns of copper alloys which contains a very small quantity ranging from about 0.05 to about 5% of an alloying metal, selected from nickel, cobalt, iron, platinum, palladium, rhodium, ruthenium and iridium. By building this alloying metal into the metal deposit the reduction-oxidation mechanism is influenced and a considerably lower quantity of hydrogen is produced than in the prior art electroless copper-plating baths which contain no alloying component. This building-in process results in an improved ductility of the deposited metal. The copper to the alloying metal ratio copper-plating is considerably higher in the solution than in the deposit.

During the experiments which were performed within the framework of the investigations which resulted in filing of the above-mentioned patent application it was also tried to build gold into a copper deposit, which lead to surprising results. It was found that starting from an electroless copper-plating bath the addition of gold salts results in a metal deposit having a much higher content of gold than corresponds to the ratio of gold ions to copper ions in the dissolved state, this being completely different from the behaviour during the production of copper deposit with one of the other, above-mentioned metals. In this manner it proved to be possible to deposit alloys having gold as their main constituent, it even being possible to deposit a gold alloy having a copper content of less than 1% by weight. It also appeared possible to obtain alloys having copper as their main constituent; all this depends *inter-alia* on the ratio of copper ions to gold ions in the electroless plating solution and on the deposition rate occurring.

According to the invention, a solution for the electroless deposition of gold alloys onto a substrate, said solution having a pH value 11—14, comprising one or more complex-forming compounds and a complex gold compound, is characterized in that the solution contains a copper salt, that a gold complex and a copper complex are taken having complexing constants, the first constant being a factor of at least $10^5$ greater than the second constant and that the solution contains formaldehyde or a formaldehyde-producing compound and alkali-metal hydroxide for adjusting the pH. It is surmised that the mechanism is based either on a catalytic effect of freshly deposited copper for the reduction of gold cyanide-ions or on replacement of copper by gold, after the copper ion has been reduced to metal by formaldehyde. In the latter case, the ratio of copper to gold in the deposit is determined by the reduction rate of the copper ions and by the speed of replacement of copper by gold. Although the plating mechanism is not fully understood, it is obvious that the formation of a copper-containing surface by reaction of cupric ions with formaldehyde as a reducing agent is essential to the catalysis. Alkaline solutions containing gold cyanide ions and formaldehyde without the addition of copper ions produce on a copper surface or on a substrate provided with Pd-nuclei no or only a very thin layer of gold whereafter the deposition completely stops.

There are different possibilities for copper complexes. A number of possibilities with the value log K of the copper complex are enumerated here. The complexing constant K is defined by the equation

2

**0 070 061**

$$K = \frac{[CuL_x^{\,(2-xm)+}]}{[Cu^{2+}]\,[L^{m-}]^x}$$

wherein L is the complexing agent.

| L | log K |
|---|---|
| nitrilotriacetic acid | 17.4 |
| ethylenediamine-N,N$^1$-diacetic acid | 16.2 |
| ethylenediaminetetra-acetic acid | 18.8 |
| ethylenediamine-isopropylphosphonic acid | 20.3 |
| ethylenediamine-N,N$^1$-dimethylphosphonic acid | 17.5 |
| ethylenediamine-tetramethylphosphonic acid | 23.0 |
| potassium sodium tartrate (pH=12) | 19.1 |

The value of log K of the potassium gold (I) cyanide is 38, of potassium gold (III) cyanide it is 56.

Preference should be given to the method in which the ethylenediamine tetra-acetic acid tetrasodium salt is used as a complex-forming agent for copper and potassium gold cyanide as a complex gold compound.

In accordance with an elaboration of the invented method it is advantageous when the solution which contains potassium gold cyanide contains in addition free, soluble, cyanide in a quantity between $10^{-2}$ and $10^{-4}$ mole/l. This addition results in a still further improved stability of the solution.

To obtain an improved stability of the solution and an optimum selectivity during the deposition of the gold alloy in accordance with a pattern it is advantageous to pass oxygen or air through the solution during the deposition process.

In accordance with a special embodiment the solution contains in addition to Cu-ions also one or more complex ions of Ni, Co, Fe, Pt, Pd, Rh, Ru or Ir.

An interesting application of the invented method is the deposition of a metal layer or pattern onto the surface of a semiconducting III-V compound, for example InSb, InP or GaAs, which provides an ohmic contact. In addition there are numerous uses in the traditional field of electroless metal deposition of layers or patterns for printed circuits and selectively or fully gold-plating of non-conducting substrates. Additive practically pure gold can now be applied in the same way as is possible for copper, so that designing and making a fully additive printed conductive patterns in gold has been made available by the invention.

A further interesting application is the selective deposition of gold alloys onto conductor paths in thick film circuits, the conductor paths being in the form of finely dispersed metal or a metal alloy such as AgPd in a vitreous matrix. In spite of the presence of a vitreous matrix, it has been found that the catalytic effect of these metals for the deposition of gold alloys were fully preserved.

Example 1

Glass plates measuring 4.9×1.2 cm$^2$ were subjected to the following treatments.

a) the plates were roughened on one side with carborundum until a roughness ($R_a$) of 0.8—1.0 μm was reached,

b) rinsed in cold water,

c) the plates were immersed for 10 seconds in a 4% solution of HF at ambient temperature,

d) rinsed in cold water,

e) the plates were degreased by keeping them immersed for at least 24 hours in a 5% solution of "Decon 90®" at ambient temperature,

f) rinsed in cold deionised water,

g) the plates were kept immersed for 1 minute in a solution comprising 100 mg SnCl$_2$ and 0.1 ml concentrated HCl per litre, which solution was at room temperature,

h) immersed for 1 minute in deionised water at ambient temperature,

i) immersed for 1 minute in a solution comprising 1 g AgNO$_3$ per litre, which solution was at ambient temperature,

j) immersed for 1 minute in deionised water at ambient temperature,

k) immersed for 1 minute in a solution containing 100 mg PdCl$_2$ and 3.5 ml concentrated HCl per litre, which solution was at ambient temperature,

3

l) immersed for 1 minute in deionised water at ambient temperature,
m) immersed for 1 minute in deionised water at 90°C.

One plate was electrolessly plated in a solution which had a temperature of 50°C and contained per litre:

0.01 mole copper sulphate
0.014 mole potassium gold(I) cyanide
0.072 mole ethylenediamine tetra-acetic acid tetra Na-salt
0.12 mole sodium hydroxide
0.30 formaldehyde.

The solution was replaced twice, each time after $1\frac{1}{2}$ hour. The quantity of metal deposited on the roughened glass surface was:

after $1\frac{1}{2}$ hour 21.6 mg
after 3 hours 40.9 mg
after $4\frac{1}{2}$ hour 57.4 mg

and its composition in a percentage by weight was 98.5% Au and 1.5% Cu.

Another plate was plated in a solution which was at a temperature of 50°C and contained 0.005 mole of copper sulphate per litre, the solution further containing the same bath components in the same concentration as described above. This solution yielded after $1\frac{1}{2}$ hour a 7.0 mg deposit which contained more than 99% by weight of Au.

A latent image consisting of palladium nuclei on a glass plate, which image was obtained in the same way as described above, contacted with a solution of the above-described composition but without copper sulphate, showed after $1\frac{1}{2}$ hour a weight increase of not more than 0.2 mg.

Example 2

Glass plates which were provided with nuclei in the manner described in Example 1 were electrolessly plated by means of the following solutions, which were heated to 50°C and contained per litre:

| | (A) | (B) |
|---|---|---|
| $CuSo_4 . 5H_2O$ | 0.035 mole | 0.035 mole |
| EDTA . 4Na | 0.135 mole | 0.072 mole |
| NaOH | 0.135 mole | 0.12 mole |
| KAu $(CN)_2$ | 0.00035 mole | 0.00017 mole |
| formaldehyde | 0.075 mole | 0.10 mole |

By contacting the glass plates with solution A, 2.5 m/cm² had been deposited after $1\frac{1}{2}$ hours onto the roughened glass, the composition of the deposit being in a percentage by weight: Au=20 and Cu=80. Solution B yielded after $1\frac{1}{2}$ hour 2.8 mg/cm² in the form of an alloy which consisted of 6.3 wt.% Au and 93.7 wt.% Cu.

Example 3

Glass plates which had been provided with nuclei as described in Example 1, were electrolessly plated at 50°C in a range of solutions having the following compositions per litre, in which the quantity of potassium gold cyanide x was varied in accordance with the following Table:

| | |
|---|---|
| $CuSO_4 . 5H_2O$ | 0.04 mole |
| ethylenediamine tetra-acetic acid 4Na | 0.072 mole |
| NaOH | 0.12 mole |
| KAu $(CN)_2$ | x |
| KCN | 0.0015 mole |
| HCHO | 0.10 mole |

The following Table shows the values of x, the rate of deposition and the composition of the resultant alloys.

4

| Solution | x (mole/litre) | Quantity of alloy deposited (mg/cm$^2$ in 2 hours) | Composition (wt.%) | |
|---|---|---|---|---|
| | | | Au | Cu |
| 1 | 0.00017 | 2.5 | 5.8 | 94.2 |
| 2 | 0.00035 | 2.8 | 7.4 | 92.6 |
| 3 | 0.00087 | 3.1 | 17.3 | 82.7 |
| 4 | 0.0017 | 3.6 | 48.3 | 51.7 |
| 5 | 0.0035 | 4.5 | 65 | 35 |
| 6 | 0.007 | 2.7 (1 hour) | 74.9 | 25.1 |
| 7 | 0.014 | 2.3 | approx. 99 | approx. 1 |

Example 4

A glass plate which was provided with nuclei as described in Example 1 was plated at 70°C in a solution which contained per litre:

0.08 mole copper sulphate

0.11 mole ethylenediamine-N,N$^1$-bisisopropylphosphonic acid

0.53 mole sodium hydroxide

0.013 mole potassium gold(I) cyanide

0.09 mole formaldehyde

After 5 hours 1.0 mg metal per cm$^2$ with a gold content of 99.9% by weight had been deposited.

Example 5

A glass plate on which nuclei were produced as described in Example 1 was plated at 50°C in a solution which contained per litre:

0.042 mole copper sulphate

0.21 mole potassium sodium tartrate

0.35 mole sodium hydroxide

0.20 mole formaldehyde and

$4 \times 10^{-4}$ mole potassium gold(III)cyanide [KAu(CN)$_4$] obtained

The KAu(CN)$_4$ was added to the other constituents of the plating solution as 40 ml per litre of a solution which was obtained by dissolving 3.9 g KAuCl$_4$ . $\frac{1}{2}$H$_2$O in 100 ml of water, were taken, whereafter 2.6 g KCN was added and the solution made up to 1 l with water.

After 2 hours 8.2 mg metal had been deposited per cm$^2$ having a composition in percent by weight of 23 Au and 77 Cu.

Example 6

A glass plate which had been provided with nuclei in the manner described in Example 1 was electrolessly plated at room temperature in a solution which contained per litre:

0.042 mole copper sulphate

0.084 mole ethylenediaminetetra-acetic acid 4Na

0.105 mole sodium hydroxide

0.014 mole KAu(CN)$_2$

0.30 mole formaldehyde

After approximately 4 hours, 2.0 mg metal had been deposited per cm$^2$ with a composition in percent by weight of 91 Au and 9 Cu.

Example 7

On an epoxy resin substrate, having a surface layer of epoxy resin in which titanium dioxide particles had been dispersed was provided photochemically with a copper pattern in accordance with US Patent Specification 3,758,304. The conducting portions of the pattern were not mutually interconnected. The resultant product was first treated for 1 minute with a solution of 30 g amino-acetic acid per litre having a pH of 3.5, which solution was at ambient temperature. After rinsing in demineralised water, the copper pattern was electrolessly plated for 1 hour in a solution at 50°C, the solution containing per litre:

0.04 mole CuSO$_4$ . 5H$_2$O

0.072 mole EDTA 4Na . 4H$_2$O

0.12 mole NaOH

# 0 070 061

0.014 mole KAu(CN)$_2$
0.10 mole HCHO
A gold layer having a Au-content of approximately 99 wt.% had formed selectively everywhere on the copper pattern.

Example 8

A p-GaAs surface was treated for approximately 4 minutes at 70°C with a 20 wt.% KOH-solution in water. After a short rinse in demineralised water, nuclei were produced by contact for approximately 3 minutes with a solution at room temperature which contained 0.3 g PdCl$_2$, 9 ml of concentrated HCl (d=1.19), 864 ml of acetic acid, 22.5 ml of a 40% HF solution and 9 ml of water (J. Electrochem. Soc. *127*, 1935—1940 (1980)).

After having been rinsed for 5 minutes in running water the GaAs was metallized in a solution having the composition described in Example 7. The deposited gold alloy layer adhered well and behaved as an ohmic contact.

Example 9

Another pattern to be plated consists of AgPd conductors in a vitreous matrix, provided on an aluminium oxide plate by means of screen printing.

The plate was electrolessly plated in a solution having the composition specified in Example 1 and which was at a temperature of 50°C, oxygen being slowly passed through the solution.

A metal layer having an adequate selectivity was deposited onto the AgPd pattern.

**Claims**

1. A solution for the electroless deposition of gold alloys onto a substrate having a pH 11—14 comprising one or more complex-forming compounds and a complex gold compound, characterized in that the solution contains a copper salt, that a gold complex and a copper complex are taken having complexing constants, the first constant being a factor of at least $10^5$ greater than the second constant and that the solution contains formaldehyde or a formaldehyde-producing compound and alkali-metal hydroxide for adjusting the pH.

2. A solution as claimed in Claim 1, characterized in that it comprises potassium gold cyanide as the complex gold compound.

3. A solution as claimed in Claim 1 or 2, characterized in that it comprises the cupric complex of ethylenediamine tetra-acetic acid tetra Na-salt.

4. A solution as claimed in one of the Claims 1 to 3, characterized in that it also contains soluble CN$^-$ in a concentration between $10^{-2}$ and $10^{-4}$ mole/litre.

5. A solution as claimed in one of Claims 1 to 4, characterized in that in addition to Cu-ions it also comprises one or more complex ions of Co, Fe, Ni, Pt, Pd, Rh, Ru or Ir.

6. A method of electrolessly depositing gold-alloy layers and patterns onto a substrate by contacting said substrate with a solution having a pH-value 11—14, which comprises one or more complex-forming compounds for metal ions and a complex gold compound, characterized in that the solution according to the claims 1 to 5 is used.

7. Use of the solution according to any one of Claims 1 to 5 for the production of semiconductors devices on the basis of a III-V compound, the surface of which device is provided with a layer or pattern of gold or a gold-alloy.

**Patentansprüche**

1. Eine Lösung zur stromlosen Abscheidung von Goldlegierungen auf einem Substrat, mit einem pH-Wert von 11 bis 14, mit einer oder mehreren komplexbildenden Verbindungen und mit einer komplexen Goldverbindung, dadurch gekennzeichnet, dass die Lösung ein Kupfersalz enthält, dass ein Goldkomplex und ein Kupferkomplex eingesetzt werden, die Komplexierungskonstanten aufweisen, wobei die erste Konstante um einen Faktor von wenigstens $10^5$ grösser ist als die zweite Konstante, und dass die Lösung Formaldehyd oder eine formaldehyderzeugende Verbindung sowie Alkalimetallhydroxid zur Einstellung des pH-Wertes enthält.

2. Lösung nach Anspruch 1, dadurch gekennzeichnet, dass sie Kaliumgoldzyanid als komplexe Goldverbindung enthält.

3. Lösung nach Anspruch 1 oder 2, dadurch gekennzeichnet, dass sie den Kupferkomplex des Tetra-Na-Salzes der Äthylendiamintetraessigsäure enthält.

4. Lösung nach einem der Ansprüche 1 bis 3, dadurch gekennzeichnet, dass sie ausserdem lösliches CN$^-$ in einer Konzentration zwischen $10^{-2}$ und $10^{-4}$ mol/l enthält.

5. Lösung nach einem der Ansprüche 1 bis 4, dadurch gekennzeichnet, dass zusätzlich zu den Cu-Ionen ein oder mehrere komplexe Ionen von Co, Fe, Ni, Pt, Pd, Rh, Ru oder Ir vorhanden sind.

6. Verfahren zum stromlosen Abscheiden von Goldlegierungsschichten und -mustern auf einem Substrat, bei dem das Substrat mit einer Lösung mit einem pH-Wert von 11 bis 14 kontaktiert wird, wobei

6

die Lösung eine oder mehrere komplexbildende Verbindungen für Metallionen und eine komplexe Goldverbindung enthält, dadurch gekennzeichnet, dass die Lösung nach den Ansprüchen 1 bis 5 verwendet wird.

7. Verwendung der Lösung nach einem der Ansprüche 1 bis 5 zum Herstellen von Halbleiteranordnungen auf Basis einer III-V-Verbindung, wobei die Oberfläche einer derartigen Anordnung mit einer Schicht bzw. einem Muster aus Gold oder einer Goldlegierung versehen wird.

## Revendications

1. Solution pour le dépôt sans courant électrique d'alliages d'or sur un substrat, à pH de 11—14, contenant un ou plusieurs composés formateurs de complexes et un composé d'or complexe, caractérisé en ce que la solution contient un sel de cuivre, qu'un complexe d'or et un complexe de cuivre sont pris qui présentent des constantes de complexe, la première constante étant supérieure d'un facteur d'au moins $10^5$ à la deuxième constante et que la solution contient du formaldéhyde ou un composé formateur de formaldéhyde et un hydroxyde d'un métal alcalin servant à régler le pH.

2. Solution selon la revendication 1, caractérisée en ce qu'elle contient du cyanure d'or-potassium comme composé d'or complexe.

3. Solution selon la revendication 1 ou 2, caractérisée en ce qu'elle contient un complexe cuivrique de sel tétrasodique d'acide d'éthylène-diamine-tétra-acétique.

4. Solution selon l'une des revendications 1 à 3, caractérisée en ce qu'elle contient du $CN^-$ soluble dans une concentration comprise entre $10^{-2}$ et $10^{-4}$ mole/litre.

5. Solution selon l'une des revendications 1 à 4, caractérisée en ce qu'outre les ions Cu, elle contient également un ou plusieurs ions complexes de Co, Fe, Ni, Pt, Pd, Rh, Ru ou Ir.

6. Procédé pour le dépôt sans courant électrique de couches et de configurations en alliage d'or sur un substrat par contact dudit substrat avec une solution présentant une valeur de pH de 11—14, contenant un ou plusieurs composés formateurs de complexes pour les ions métalliques et un composé d'or complexe, caractérisé par l'utilisation de la solution selon les revendications 1 à 5.

7. Application de la solution selon l'une des revendications 1 à 5 pour la réalisation de dispositifs semiconducteurs à base d'un composé III-V, dispositif dont la surface est munie d'une couche ou d'une configuration en or ou en un alliage d'or.